Europäisches Patentamt

European Patent Office

Office européen des brevets

(11) Publication number: **0 186 667**
**B1**

(12) **EUROPEAN PATENT SPECIFICATION**

(45) Date of publication of patent specification: 01.06.88

(21) Application number: 85902088.5

(22) Date of filing: 09.05.85

(86) International application number:
PCT/GB85/00196

(87) International publication number:
WO 85/05496 05.12.85 Gazette 85/26

(51) Int. Cl.⁴: **H 01 L 23/12, H 01 L 23/14,**
**H 01 L 23/36, H 01 L 23/48**

(54) **MOUNTING SEMI-CONDUCTOR CHIPS.**

(30) Priority: 24.05.84 GB 8413330

(43) Date of publication of application:
09.07.86 Bulletin 86/28

(45) Publication of the grant of the patent:
01.06.88 Bulletin 88/22

(84) Designated Contracting States:
AT BE CH DE FR GB IT LI LU NL SE

(56) References cited:
EP-A-0 055 578
EP-A-0 072 673
DE-A-2 546 443
US-A-3 777 220

Patent Abstracts of Japan, vol. 7, no. 45,
(E-160)(1190), 23. February 1983 & JP-A-
57196548 (TOKYO SHIBAURA) 2 December
1982

(73) Proprietor: MBM TECHNOLOGY LIMITED
Victoria Road
Portslade, East Sussex BN4 1YH (GB)

(72) Inventor: TAYLOR, Kenneth
96 Woodfield Drive East Barnet
Hertfordshire EN4 8PB (GB)

(74) Representative: Weston, Robert Dale et al
c/o PHILLIPS & LEIGH 7 Staple Inn
Holborn London WC1V 7QF (GB)

Courier Press, Leamington Spa, England.

## Description

This invention relates to mounting semi-conductor chips, such as integrated circuit dies or discrete components on an electronic circuit mount such as a circuit or wiring board to form an electronic sub-assembly.

Conventional printed circuit boards are formed of a thin board (of between 0.0127 mm and 32 mm thickness) with a conducting interconnected pattern formed on one or both faces of the board; feedthroughs and vias being provided to connect the interconnection patterns on either face of the board and for wires or leads from discrete components, semi-conductor chips and integrated circuit dies that are often mounted on carriers which are then added to complete the circuit for the thus formed sub-assembly. Printed circuits have also been produced with several alternating layers of metal film and insulating film mounted on a single board; boards with up to 32 layers of interconnections have been produced. Such multilayer boards have enhanced components/chips/die packing densities and reduced interconnection lengths resulting in higher operating speeds for the sub-assembly.

United Kingdom Patent Specification No. 953503 (Telefunken) describes the mounting of an active circuit element in a recess at one side of a carrier plate of insulating material, the only insulating material disclosed being ceramic material. United Kingdom Patent Specification No. 2026234A (Mitsumi) also describes the accommodation of a circuit element chip within a concavity or depression in a ceramic substrate, the use of substrate materials other than ceramic is contra-indicated by the disclosure of this specification (see page 1 lines 31 to 34).

It is an object of the present invention to provide an electronic circuit mount having recesses to house semi-conductor chips and being easily moulded, inexpensive and, for high frequency operations, having improved dielectric characteristics. This can be achieved by moulding from thermoplastic material. However, the drawback to the use of thermoplastic material is its ease of thermal degradation and it is a further object of the present invention to overcome this defect.

According to the present invention, an electronic circuit mount, for semi-conductor chips, has a series of closed-bottomed recesses within the thickness of the mount, with each recess opening to a surface of the mount and being shaped to house a semi-conductor chip of given configuration; the mount having an applied pattern of chip-interconnecting electrical conductors extending over the mount and to each recess; the mount being moulded from thermoplastic material and each recess having means for conducting away and dissipating heat therefrom. In use, the heat conducting and dissipating means convey heat generated by a chip away from the recess it is mounted in and prevents the thermoplastic of the mount in the area of the recess from degrading.

In an embodiment of the present invention, the heat conducting and dissipating means comprise one or more thermal vias extending from each recess to another surface of the mount.

In a further embodiment of the present invention, the heat conducting and dissipating means further comprise an applied thermal conducting layer extending over part of each recess, the or each thermal via and a part of said other surface of the mount. By this means, a chip attached, such as by bonding, to the thermal conducting layer in a recess has the heat it generates conducted away through the thermal via and radiated from the layer on said other surface.

In a preferred embodiment of the present invention, the mount is a circuit board, the recesses each open to one of the opposed faces of the board, the thermal vias extend from the bottom of each recess to the opposite board face and the thermal conducting layer extends over the bottom of each recess.

Conveniently, the pattern of electrical conductors and the thermal conducting layer are simultaneously applied to the mount by a process of selective metalisation.

A cover for each recess may be provided in the form of a lid moulded from thermoplastic material and shaped to fit the sides of the recess and to be flush with the mount surface.

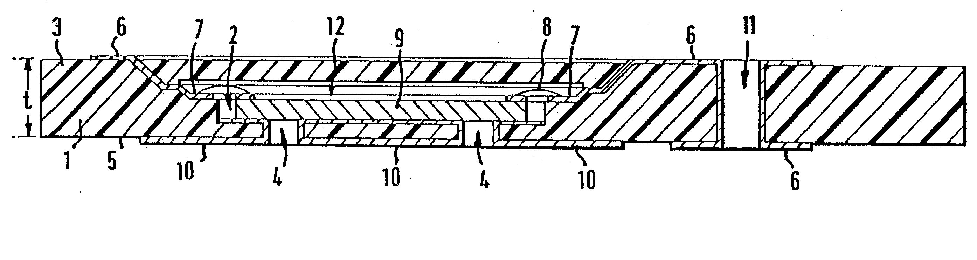

The above and other features of the present invention are illustrated, by way of example, by the Drawing of a section through an electronic circuit mount in accordance with the invention but showing only one recess.

As shown a board 1 has a recess 2 in one face 3 thereof; as shown the recess is within the thickness of the board (in an example the thickness is 1.6 mm).

Thermal vias or holes 4 are provided in the bottom of the recess 2, which vias emerge on the opposite face 5 of the board. The board is provided with an applied pattern 6 of chip-interconnecting electrical conductors that covers face 3 of the board and extends down into the recess 2 to provide wiring connection points 7 for the electrical connection of wiring-leads 8 to a semi-conductor chip 9, such as an integrated circuit die that is housed in the recess.

The bottom of the recess, the thermal vias 4 and a part of the opposite face 5 of the board are covered with a thermal conducting layer 10 the chip 9 being bonded, such as by a thermally conductive adhesive, to the layer in the recess bottom. The thermal vias 4 and conducting layer 10 serve to conduct heat from the semi-conductor chip 9 to the thermal coating on the other side of the board which forms a spreader plane to radiate the heat generated in the semi-conductor device.

Feedthroughs for the board 1 are provided in the form of vias 11 from one to the other sides of the board through which vias the conducting pattern 6 can extend.

The recess 2 is covered by a lid 12 that is shaped to fit the sides of the recess and be essentially flush with the surface of the board face 3. Additionally, the remaining free space 13 within the recess can be filled with an insulating material, such as an epoxy resin to "pot" the chip in the device both to anchor it therein and provide additional protection beyond that provided by the lip 12.

The board may be formed using high performance thermoplastic materials either filled or unfilled of the type polyethyersulphone, polysulphone, polyetherimide, polyphenylene sulphide or the like and may be produced by injection moulding or any other suitable technique. The electrical conducting interconnection pattern 6 is then produced on the board sides and into the recess by selective metallisation. The thermal conducting layer 10 is also formed by selective metallisation, preferably by the same operation as that forming the electrical conducting pattern 6.

The lid 12 can be similarly formed and from similar materials and is adhesively bonded or welded into place, after filling any free space within the recess with an epoxy resin potting compound.

More than one recess is provided on each board to mount further semi-conductor chips or devices and further chips or devices may be surface mounted or through hole mounted on to the board to provide a complete electronic sub-assembly that can be functionally tested before further assembly.

The composite structure of the thus formed electronic sub-assembly will operate at much higher speeds than conventionally packaged and interconnected systems due to the short interconnection lengths possible and the low dielectric constant of the materials used; whilst the thermal conduction means prevents the board from overheating in the area of each recess, to the detriment of both the chip and the board thermoplastic material.

## Claims

1. An electronic circuit mount, for semi-conductor chips, having a series of closed-bottomed recesses within the thickness of the mount, each recess opening to a surface of the mount and being shaped to house a semi-conductor chip of given configuration; the mount having an applied pattern of chip-interconnecting electrical conductors extending over the mount and to each recess characterised in that the mount is moulded from thermoplastic material and each recess has means for conducting away and dissipating heat therefrom.

2. A mount as claimed in claim 1, and characterised in that said heat conducting and dissipating means comprise one or more thermal vias extending from each recess to another surface of the mount.

3. A mount as claimed in claim 2, and characterised in that said heat conducting and dissipating means further comprise an applied thermal conducting layer extending over part of each recess, the or each thermal via and a part of said other surface of the mount.

4. A mount as claimed in claim 3, and characterised in that the mount is a circuit board, the recesses each open to one of the opposed faces of the board, the thermal vias extend from the bottom of each recess to the opposite board face and the thermal conducting layer extends over the bottom of each recess.

5. A mount as claimed in claim 3 or claim 4, and characterised in that the pattern of electrical conductors and the thermal conducting layer are simultaneously applied to the mount.

6. A mount as claimed in claim 3 or claim 4, and characterised in that the pattern of electrical conductors and the thermal conducting layer are both formed by selective metallisation of the mount.

7. A mount as claimed in any of claims 1 to 6, and characterised in that the thermoplastic material is a high performance thermoplastic selected from the group polyethersulphone, polysulphone, polyetherimide, polyphenylene sulphide.

8. A mount as claimed in any of claims 1 to 7, and characterised in that means are attached to the mount to cover each recess.

9. A mount as claimed in claim 8 and characterised in that each said cover means is a lid moulded from thermoplastic material and shaped to fit the sides of the recess and to be flush with the mount surface.

## Patentansprüche

1. Stromkreismontierung für Halbleiterchips, die eine Serie von Aussparungen mit geschlossenem Boden innerhalb der Dicke der Montierung aufweisen, wobei sich jede Aussparung in Richtung auf eine Fläche der Montierung öffnet und so geformt ist, dass ein Halbleiterchip einer vorbestimmten Konfiguration darin eingebaut werden kann; wobei die Montierung ein angebrachtes Muster von elektrischen Leitern aufweist, die die Chips miteinander verbindet und über die Montierung hinaus und zu jeder Aussparung reicht, dadurch gekennzeichnet, dass die Montierung aus thermoplastischem Material geformt wird und dass jede Aussparung Mittel zum Wegleiten und Ableiten von Hitze aufweist.

2. Montierung nach Anspruch 1 und dadurch gekennzeichnet, dass besagte hitzeleitende und -ableitende Mittel einen oder mehrere thermische Durchgänge umfassen, die sich von jeder Aussparung bis zu einer anderen Fläche der Montierung erstrecken.

3. Montierung nach Anspruch 2 und dadurch gekennzeichnet, dass besagte hitzeleitenden und -ableitenden Mittel ferner eine angebrachte, thermisch leitende Schicht umfassen, die sich teilweise über jede Aussparung, den oder jeden thermischen Durchgang und teilweise über besagte andere Fläche der Montierung erstreckt.

4. Montierung nach Anspruch 3 und dadurch gekennzeichnet, dass die Montierung eine Schaltplatte ist, wobei jede der Aussparungen sich in Richtung auf eine der gegenüberliegenden Flächen der Platte öffnen, die thermischen Durchgänge sich vom Boden jeder Aussparung in Richtung auf die gegenüberliegende Plattenfläche erstrecken und die thermisch leitende Schicht sich über den Boden jeder Aussparung erstreckt.

5. Montierung nach Anspruch 3 oder Anspruch 4 und dadurch gekennzeichnet, dass das Muster der elektrischen Leiter und die thermisch leitende Schicht gleichzeitig auf der Montierung angebracht werden.

6. Montierung nach Anspruch 3 oder Anspruch 4 und dadurch gekennzeichnet, dass das Muster der elektrischen Leiter und die thermisch leitende Schicht beide durch selektive Metallisierung auf der Montierung gebildet werden.

7. Montierung nach einem der Ansprüche 1 bis 6 und dadurch gekennzeichnet, dass das thermoplastische Material ein Hochleistungsthermoplast aus der Gruppe Polyethersulfon, Polysulfon, Polyetherimid und Polyphenylsulfid ist.

8. Montierung nach einem der Ansprüche 1 bis 7 und dadurch gekennzeichnet, dass Mittel zum Abdecken jeder Aussparung auf der Montierung angebracht werden.

9. Montierung nach Anspruch 8 und dadurch gekennzeichnet, dass jedes dieser Abdeckmittel ein aus thermoplastischem Material geformter Deckel und so geformt ist, dass er mit den Seiten der Aussparung übereinstimmt und mit der Montierungsfläche bündig ist.

## Revendications

1. Supporte de circuit électronique pour des pulses de semi-conducteurs, ayant une série de cavités à fond fermé formées à l'intérieur de l'épaisseur du support, chaque cavité s'ouvrant sur une surface du support et étant formée pour recevoir une puce de semi-conducteurs de configuration donnée, un réseau de conducteurs électriques de raccordement des puces entre elles éant appliqué sur le support et sur chaque cavité, caractérisé en ce qu'il est moulé en matière thermoplastique et que des moyens sont prévus dans chaque cavité pour en évacuer la chaleur et la dissiper.

2. Support selon la revendication 1, caractérisé en ce que les moyens d'évacuation et de dissipation de la chaleur sont constitués par un ou plusieurs trajets thermiques s'étendant de chaque cavité à une autre surface du support.

3. Support selon la revendication 2, caractérisé en ce que ces moyens d'évacuation et de dissipation de la chaleur comportent en outre une couche appliquée conductrice de la chaleur et s'étendant sur une partie de chaque cavité, sur le ou chaque trajet thermique et sur une partie de l'autre surface du support.

4. Support selon la revendication 3, caractérisé en ce que le support est une plaquette de circuits imprimés, en ce que chaque cavité s'ouvre sur l'une des faces opposées de la plaquette, en ce que les trajets thermiques s'étendent depuis le fond de chaque cavité jusqu'à la face opposée de la plaquette et en ce que la couche conductrice de la chaleur s'étend sur le fond de chaque cavité.

5. Support selon la revendication 3 ou la revendication 4, caractérisé en ce que le réseau de conducteurs électriques et la couche conductrice de la chaleur sont appliqués simultanément sur le support.

6. Support selon la revendication 3 ou la revendication 4, caractérisé en ce que le réseau de conducteurs électriques et la couche conductrice de la chaleur sont tous deux formés par métallisation sélective du support.

7. Support selon l'une quelconque des revendications 1 à 6, caractefrisé en ce que la matière thermoplastique est une matière synthétique thermoplastique choisie dans le groupe comprenant les polyéthersulfones, polysulfones, polyéthérimides et sulfures de polyphénylène.

8. Support selon l'une quelconque des revendications 1 à 7, caractérise en ce que des moyens sont fixés sur le support pour recouvrir chaque cavité.

9. Support selon la revendication 8, caractérisé en ce que chaque moyen de recouvrement est un couvercle moulé en mantière thermoplastique et formé pour s'ajuster sur les côtés de la cavité en affleurant la surface du support.